(19) Europäisches Patentamt
European Patent Office
Office européen des brevets

(11) **EP 4 456 417 A1**

(12) **EUROPEAN PATENT APPLICATION**
published in accordance with Art. 153(4) EPC

(43) Date of publication:
**30.10.2024 Bulletin 2024/44**

(21) Application number: **23792093.9**

(22) Date of filing: **12.04.2023**

(51) International Patent Classification (IPC):
**H02S 50/00** *(2014.01)*

(52) Cooperative Patent Classification (CPC):
**H02S 50/00**

(86) International application number:
**PCT/KR2023/004923**

(87) International publication number:
**WO 2023/204515 (26.10.2023 Gazette 2023/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.04.2022 KR 20220047492**

(71) Applicant: **Hanwha Solutions Corporation
Jung-gu
Seoul 04541 (KR)**

(72) Inventor: **KIM, Do Yun
Seoul 04541 (KR)**

(74) Representative: **Mooser, Sebastian Thomas
Wuesthoff & Wuesthoff
Patentanwälte und Rechtsanwalt PartG mbB
Schweigerstraße 2
81541 München (DE)**

(54) **APPARATUS FOR INSPECTING INSULATION STATE OF PHOTOVOLTAIC MODULE, AND METHOD FOR INSPECTING INSULATION STATE BY USING SAME**

(57)     Provided is a device for checking the insulation status of a photovoltaic module, the device including a photovoltaic module, a bridge circuit connected to the photovoltaic module and having two first resistors connected in series and two second resistors connected in series such that the two first resistors and the two second resistors are connected in parallel, a sensor unit detecting a PV voltage of the photovoltaic module and a bridge voltage between a first node as a contact of the two first resistors and a second node as a contact of the two second resistors, a relay connected between the first node or the second node and the ground, a controller closing or opening the relay, and an calculation unit calculating an insulation resistance between the photovoltaic module and the ground based on the PV voltage and the bridge voltage.

FIG. 1

EP 4 456 417 A1

**Description**

**Technical Field**

The present disclosure relates to a device and method for checking the insulation status of a photovoltaic module.

**Background Art**

In general, a photovoltaic power generation system is a system that utilizes solar cells (photovoltaic cells) to convert solar energy into electrical energy and transmit the electrical energy to the commercial power grid, which system is non-polluting and semi-permanent.

Various types of photovoltaic cells used for photovoltaic cell power generation are being developed, including inorganic photovoltaic cells, dye-sensitized photovoltaic cells, and organic photovoltaic cells, which have low output voltage and relatively high current. In contrast, because the output voltage is high and the current is relatively low, multiple photovoltaic cells are commonly connected to form a module, which is called a photovoltaic module, wherein multiple photovoltaic modules connected in series are called a string, and multiple strings connected in parallel are called an array.

IEC6219-2 specifies that photovoltaic modules and power conversion devices connected to photovoltaic modules determine the insulation resistance status of photovoltaic modules before initial operation.

In this way, the standard test required by IEC6219-2C is specified to be tested only under specific conditions, but in the actual environment, cases of misjudgment of insulation status frequently occur due to malfunctions caused by various variables even though the insulation status is in a normal range.

In other words, the voltage of the photovoltaic module may not be the maximum voltage in the actual environment, that is, it may stay in the low voltage range, and in this case, the conventional technology has a problem of misjudging the insulation state because the insulation resistance value may not be accurately calculated in this range.

**Disclosure**

**Technical Problem**

In order to solve the problem of the conventional technology as described above, the present disclosure aims to provide a device for accurately checking the insulation status of a photovoltaic module and an insulation status checking method using the same.

In addition, the present disclosure aims to provide a device for checking the insulation status of a photovoltaic module with reduced dispersion range of insulation resistance by using resistors constituting a bridge circuit, and an insulation status checking method using the same.

The technical problems to be achieved by the present disclosure are not limited to the technical problems mentioned above, and other technical problems not mentioned may be clearly understood by those skilled in the art to which the present disclosure pertains from the description below.

**Technical Solution**

In order to solve the above problems, the present disclosure provides a device for checking the insulation status of a photovoltaic module, the device including a photovoltaic module, a bridge circuit connected to the photovoltaic module and having two first resistors connected in series and two second resistors connected in series such that the two first resistors and the two second resistors are connected in parallel, a sensor unit detecting a PV voltage of the photovoltaic module and a bridge voltage between a first node as a contact of the two first resistors and a second node as a contact of the two second resistors, a relay connected between the first node or the second node and the ground, a controller closing or opening the relay, and an calculation unit calculating an insulation resistance between the photovoltaic module and the ground based on the PV voltage and the bridge voltage.

Here, the bridge circuit may be configured such that a third node as one of the contacts of the two first resistors and two second resistors is connected to a positive terminal of the photovoltaic module, and a fourth node as the other contact is connected to a negative terminal of the photovoltaic module.

In addition, the sensor unit may detect the PV voltage and the bridge voltage when the relay is closed.

In addition, the device for checking the insulation status of the photovoltaic module according to the present disclosure may further include a determination unit determining the insulation status of the photovoltaic module based on the insulation resistance.

Here, the determination unit may determine an abnormal insulation status of the photovoltaic module when the insulation resistance is less than a reference value.

In addition, the calculation unit may calculate a first insulation resistance between the third node and the ground or a second insulation resistance between the fourth node and the ground depending on the polarity of the bridge voltage.

In addition, the calculation unit may calculate the first insulation resistance when the bridge voltage is a negative voltage, or the second insulation resistance when the bridge voltage is a positive voltage.

In addition, the bridge circuit further includes a bridge resistor connected between the first node and second node, and the sensor unit may detect a voltage across the bridge resistor as the bridge voltage.

In addition, the calculation unit may calculate the insulation resistance based on the resistance values of the first resistors, the second resistors, and the bridge resistor, the PV voltage, and the bridge voltage.

In addition, the resistance values of the first and second resistors may be equal to each other.

In addition, the sensor unit may detect an offset voltage between the first node and second node when the relay is opened.

In addition, the device for checking the insulation status of the photovoltaic module according to the present disclosure may further include an offset correction unit correcting the bridge voltage by reflecting the offset voltage on the bridge voltage.

Here, the calculation unit may calculate the insulation resistance based on the bridge voltage corrected by the offset correction unit.

In addition, the device for checking the insulation status of the photovoltaic module according to the present disclosure may further include a level conversion unit converting the PV voltage and the bridge voltage into a level that the calculation unit is able to process and providing the converted level to the calculation unit.

In order to solve the above problems, the present disclosure provides a method of checking the insulation status of a photovoltaic module, performed by the insulation status checking device, the method including: individually storing resistance values of two first resistors connected in series, two second resistors connected in series, a bridge resistor of a bridge circuit connected to the photovoltaic module; in a state of a relay connected between a first node as a contact of the two first resistors or a second node as a contact of the two second resistors and the ground being closed, detecting a PV voltage of the photovoltaic module and a bridge voltage between the first node and the second node; calculating an insulation resistance of the photovoltaic module based on the resistance values of the first resistors, the second resistors, and the bridge resistor, the PV voltage, and the bridge voltage; and determining a normal insulation status when the insulation resistance is a reference resistance value or more.

The detecting step may further include: detecting an offset voltage between the first node and the second node in a state of the relay being opened; and correcting the bridge voltage based on the offset voltage.

**Advantageous Effects**

According to the present disclosure, there are advantages of accurately checking the insulation status of the photovoltaic module before connected to a power conversion device of the photovoltaic module, in particular even when the photovoltaic module is not in a maximum voltage range, but in a low voltage range. Accordingly, the risk of electric shock or fire due to ground fault current may be prevented.

According to the present disclosure, even when the resistance value of the insulation resistance has a wide distribution range depending on the types of photovoltaic modules or power conversion devices, there is an advantage in that the distribution range of the insulation resistance may be reduced with resistors constituting the bridge circuit.

The effects that may be obtained from the present disclosure are not limited to the effects mentioned above, and other effects not mentioned may be clearly understood by those skilled in the art to which the present disclosure pertains from the description below.

**Description of Drawings**

FIG. 1 is a block diagram illustrating a device for checking the insulation status of a photovoltaic module according to an embodiment of the present disclosure.
FIG. 2 is a diagram illustrating a bridge circuit of the device for checking the insulation status of the photovoltaic module according to an embodiment of the present disclosure.
FIGS. 3 and 4 are diagrams illustrating a method of calculating the insulation resistance using the device for checking the insulation state of the photovoltaic module according to an embodiment of the present disclosure.
FIG. 5 is a flow chart illustrating a method of checking the insulation status of a photovoltaic module according to an embodiment of the present disclosure.

**Best Mode**

The above objectives, configurations, and the resulting effects of the present disclosure will become clearer through the following detailed description in conjunction with the accompanying drawings, and thus the technical idea of the present disclosure will be easily implemented by those skilled in the art to which the present disclosure pertains. In addition, in describing the present disclosure, when it is determined that a detailed description of known technologies related to the present disclosure may unnecessarily obscure the gist of the present disclosure, the detailed description will be omitted.

In this specification, terms such as "or" and "at least one" may refer to one of words listed together, or a combination of two or more. For example, "A or B" or "at least one of A and B" may refer to only A or B, or both A and B.

In this specification, terms such as 'first', 'second', or the like may be used to describe various components, but the components should not be limited by the above term. In addition, the above term should not be interpreted as limiting the order of each component, but may be used to distinguish one component from another component. For example, a 'first component' may be named a 'second component', and similarly, a 'second component' may also be named a 'first component'.

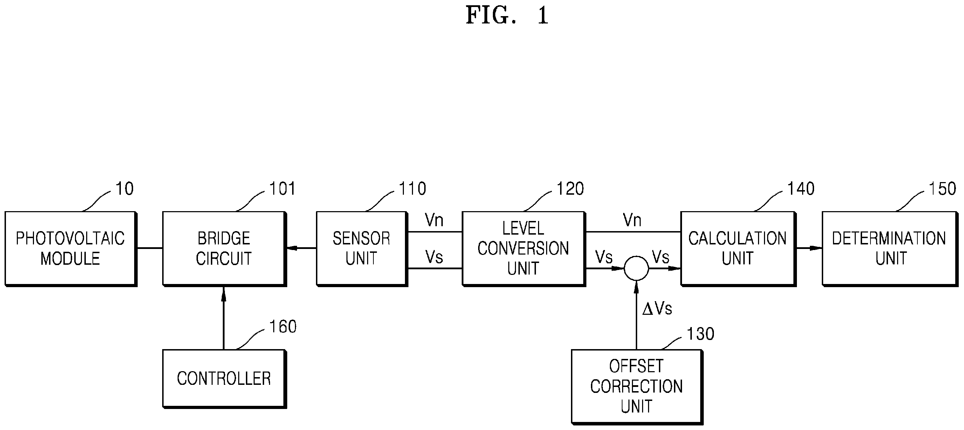

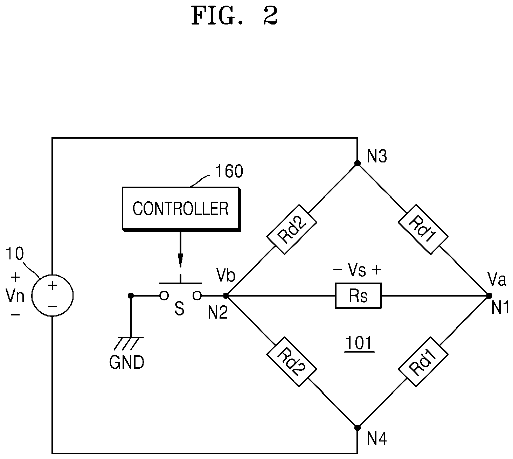

FIG. 1 is a block diagram illustrating a device for checking the insulation status of a photovoltaic module according to an embodiment of the present disclosure, and FIG. 2 is a diagram illustrating a bridge circuit of the device for checking the insulation status of the photovoltaic module according to an embodiment of the present disclosure.

Referring to FIGS. 1 and 2, the device for checking the insulation status of the photovoltaic module includes a photovoltaic module 10, a bridge circuit 101, a sensor unit 110, a level conversion unit 120, an offset correction unit 130, a calculation unit 140, a determination unit 150, and a controller 160.

The bridge circuit 101 is connected to the photovoltaic module 10 to check the insulation status between the photovoltaic module 10 and the ground GND before being connected to a power conversion device (not shown) that converts the power generated by the photovoltaic module 10. Afterwards, when there is no abnormality in the insulation status of the bridge circuit 101, the connection with the photovoltaic module 10 is released, and the photovoltaic module 10 is connected to the power conversion device.

The bridge circuit 101 includes two first resistors Rd1 connected in series and two second resistors Rd2 connected in series such that the two first resistors Rd1 and the two second resistors Rd2 may be connected in parallel.

Here, the resistance values of the first resistors Rd1 and the second resistors Rd2 may be equal to each other.

The bridge circuit 101 may further include a bridge resistor Rs connected between a first node N1 and a second node N2.

In the bridge circuit 101, a third node N3, which is one of contacts of the two first and second resistors Rd1 and Rd2, is connected to a positive (+) terminal of the photovoltaic module 10, and a fourth node, which is the other contact, is connected to a negative (-) terminal of the photovoltaic module 10.

Theoretically, in the bridge circuit 101, when the product of the resistance values of a pair of first and second resistors Rd1 and Rd2 facing each other and the resistance values of the first and second resistors Rd1 and Rd2 of another pair of first and second resistors facing each other are equal to each other, the current flowing through the bridge resistor Rs becomes zero (0) and the voltage applied across the bridge resistor Rs becomes zero (0) (equilibrium state).

The sensor unit 110 may detect a PV voltage Vn of the photovoltaic module 10, and a bridge voltage Vs between a first node N1, which is a contact of the two first resistors Rd1, and a second node N2, which is a contact of the two second resistors Rd2. Here, the sensor unit 110 may include a voltage sensor.

A relay S may be connected between the first node N1 and the ground GND, or between the second node N2 and the ground GND to check the insulation status between the photovoltaic module 10 and the ground GND.

The controller 160 may close or open the relay S.

The sensor unit 110 may detect the PV voltage Vn and the bridge voltage Vs when the relay (S) is closed.

Here, the sensor unit 110 may detect the voltage across the bridge resistor Rs as the bridge voltage Vs.

The calculation unit 140 may calculate the insulation resistance between the photovoltaic module 10 and the ground GND based on the PV voltage Vn and the bridge voltage Vs. More specifically, the calculation unit 140 may calculate the insulation resistance based on the resistance values of the first resistor Rd1, the second resistor Rd2, and the bridge resistor Rs, the PV voltage Vn, and the bridge voltage Vs. Here, the calculation unit 140 stores in advance the resistance values of the first resistor Rd1, the second resistor Rd2, and the bridge resistor Rs.

On the other hand, the insulation resistance may vary depending on the types of photovoltaic modules 10 or power conversion devices. That is, the resistance value of the insulation resistance has a wide distribution range. This environment acts as an obstacle to accurately detect the insulation resistance. However, the present disclosure has an advantage of reducing the distribution range of the insulation resistance with the second resistor Rd2.

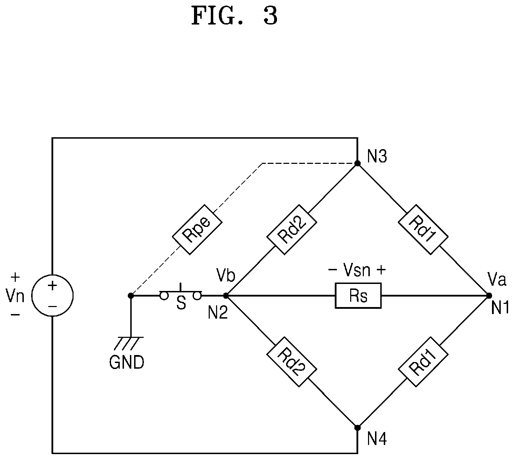

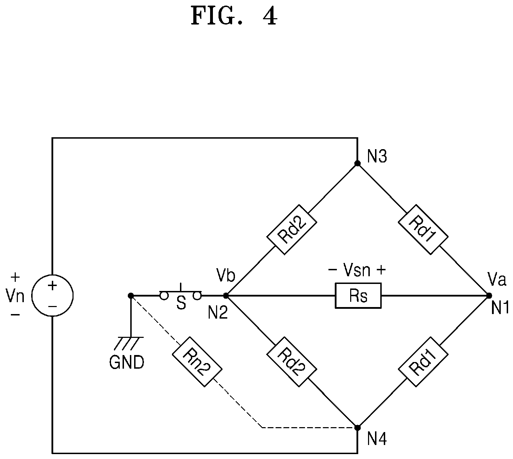

FIGS. 3 and 4 are diagrams illustrating a method of calculating the insulation resistance using the device for checking the insulation state of the photovoltaic module according to an embodiment of the present disclosure.

Referring to FIGS. 3 and 4, the calculation unit 140 may calculate a first insulation resistance Rpe between a third node N3 and the ground GND or a second insulation resistance Rne between a fourth node N4 and the ground GND depending on the polarity of the bridge voltage Vs.

Referring to FIG. 3, the calculation unit 140 may calculate the first insulation resistance Rpe when the bridge voltage Vs is a negative (-) voltage.

Specifically, when the bridge voltage Vs is detected as a negative voltage less than 0 after the relay S is closed, it may be determined that the value of the first insulation resistance Rpe decreases in the bridge equilibrium state. Accordingly, the calculation unit 140 calculates the first insulation resistance Rpe when the bridge voltage Vs is a negative voltage.

Hereinafter, how to calculate the first insulation resistance Rpe will be described in detail through mathematical equations.

First, for convenience in developing the equations, the combined parallel resistance value of the second resistor Rd2 and the first insulation resistance Rpe will be replaced with the first parallel resistance Rpf as shown in Equation 1 below.

【Equation 1】

$$Rpf = \frac{Rd2 \cdot Rpe}{Rd2 + Rpe}$$

By applying Kirchhoff's current law at the second node N2, Equation 2 below may be derived.

【Equation 2】

$$\frac{Vn - Vb}{Rpf} = -\frac{Vs}{Rs} + \frac{Vb}{Rd2}$$

In Equation 2, Vb is a voltage of the second node N2.

When Equation 2 above is rearranged for Vb, it may be expressed as Equation 3 below.

【Equation 3】

$$Vb = \frac{Rd2 \cdot Vn + \dfrac{Rpf \cdot Rd2 \cdot Vs}{Rs}}{Rpf + Rd2}$$

In addition, by applying Kirchhoff's current law at the first node N1, Equation 4 below may be derived.

【Equation 4】

$$\frac{Vn - Va}{Rd1} = \frac{Vs}{Rs} + \frac{Va}{Rd1}$$

In Equation 4, Va is a voltage of the first node N1.

When Equation 4 above is rearranged for Va, it may be expressed as Equation 5 below.

【Equation 5】

$$Va = \frac{Vn - \frac{Rd1}{Rs}Vs}{2}$$

By calculating the bridge voltage Vs using Equation 3 and Equation 5 above, Equation 6 below may be derived.

【Equation 6】

$$Va - Vb = Vs = \frac{Vn - \frac{Rd1}{Rs}Vs}{2} - \frac{Rd2 \cdot Vn + \frac{Rpf \cdot Rd2 \cdot Vs}{Rs}}{Rpf + Rd2}$$

By rearranging the terms of Equation 6 above, it may be expressed as Equation 7 below.

【Equation 7】

$$Rpf \cdot (2 \cdot Vs - Vn + \frac{Rd1}{Rs}Vs + \frac{2 \cdot Rd2}{Rs}Vs) = Rd2 \cdot Vn - \frac{Rd1 \cdot Rd2}{Rs}Vs - 2 \cdot Rd2 \cdot Vn - 2 \cdot Rd2 \cdot Vs$$

In Equation 7 above, when $2 \cdot Vs - Vn + \frac{Rd1}{Rs}Vs + \frac{2 \cdot Rd2}{Rs}Vs$ is replaced with A and $Rd2 \cdot Vn - \frac{Rd1 \cdot Rd2}{Rs}Vs - 2 \cdot Rd2 \cdot Vn - 2 \cdot Rd2 \cdot Vs$ with B, Equation 7 above may be briefly expressed as Equation 8 below.

【Equation 8】

$$Rpf = \frac{B}{A}$$

By substituting Equation 1 into Equation 8 and summarizing the terms for the first insulation resistance Rpe, it may be expressed as Equation 9 below.

【Equation 9】

$$Rpe = \frac{Rd2 \cdot \frac{B}{A}}{Rd2 - \frac{B}{A}}$$

In Equation 9, since the resistance values of the first resistor Rd1, the second resistor Rd2, and the bridge resistor Rs are stored in advance in the calculation unit 140, the calculation unit 140 may calculate the resistance value of the first insulation resistance Rpe when the PV voltage Vn and the bridge voltage Vs are received from the sensor unit 110.

Referring to FIG. 4 , the calculation unit 140 may calculate the second insulation resistance Rne when the bridge voltage Vs is a positive (+) voltage.

Specifically, when the bridge voltage Vs is detected as a positive (+) voltage greater than 0 after the relay S is closed, it may be determined that the resistance value of the second insulation resistance Rne decreases in the bridge equilibrium state. Accordingly, the calculation unit 140 calculates the second insulation resistance Rne when the bridge voltage Vs is a positive (+) voltage.

Hereinafter, how to calculate the second insulation resistance Rne will be described in detail through mathematical Equations below.

First, for convenience in developing the Equations, the combined parallel resistance value of the second resistor Rd2 and the second insulation resistance Rne will be replaced with the second parallel resistance Rnf as shown in Equation 10 below.

**【Equation 10】**

$$Rnf = \frac{Rd2 \cdot Rne}{Rd2 + Rne}$$

By applying Kirchhoff's current law at the second node N2, Equation 11 below may be derived.

**【Equation 11】**

$$\frac{Vn - Vb}{Rd2} = -\frac{Vs}{Rs} + \frac{Vb}{Rnf}$$

In Equation 11, Vb is a voltage of the second node N2.

When Equation 11 above is rearranged for Vb, it may be expressed as Equation 12 below.

**【Equation 12】**

$$Vb = \frac{Rnf \cdot Vn + \dfrac{Rnf \cdot Rd2 \cdot Vs}{Rs}}{Rnf + Rd2}$$

In addition, by applying Kirchhoff's current law at the first node N1, Equation 13 below may be derived.

**【Equation 13】**

$$\frac{Vn - Va}{Rd1} = \frac{Vs}{Rs} + \frac{Va}{Rd1}$$

In Equation 13, Va is a voltage of the first node N1.

When Equation 13 above is rearranged for Va, it may be expressed as Equation 14 below.

【Equation 14】

$$Va = \frac{Vn - \frac{Rd1}{Rs}Vs}{2}$$

By calculating the bridge voltage Vs using Equation 12 and Equation 14 above, Equation 15 below may be derived.

【Equation 15】

$$Va - Vb = Vs = \frac{Vn - \frac{Rd1}{Rs}Vs}{2} - \frac{Rnf \cdot Vn + \frac{Rnf \cdot Rd2 \cdot Vs}{Rs}}{Rnf + Rd2}$$

By rearranging the terms of Equation 15 above, it may be expressed as Equation 16 below.

【Equation 16】

$$Rnf \cdot (2 \cdot Vs + Vn + \frac{Rd1}{Rs}Vs + \frac{2 \cdot Rd2}{Rs}Vs) = Rd2 \cdot Vn - \frac{Rd1 \cdot Rd2}{Rs}Vs - 2 \cdot Rd2 \cdot Vs$$

In Equation 7 above, when $2 \cdot Vs + Vn + \frac{Rd1}{Rs}Vs + \frac{2 \cdot Rd2}{Rs}Vs$ is replaced with A' and $Rd2 \cdot V - \frac{Rd1 \cdot Rd2}{Rs}Vs - 2 \cdot Rd2 \cdot Vs$ is replaced with B', Equation 16 above may be briefly expressed as Equation 17 below.

【Equation 17】

$$Rnf = \frac{A'}{B'}$$

By substituting Equation 10 into Equation 17 above and summarizing the terms for the second insulation resistance Rne, it may be expressed as Equation 18 below.

【Equation 18】

$$Rne = \frac{Rd2 \cdot \frac{B'}{A'}}{Rd2 - \frac{B'}{A'}}$$

In Equation 18, since the resistance values of the first resistor Rd1, the second resistor Rd2, and the bridge resistor Rs are stored in advance in the calculation unit 140, the calculation unit 140 may calculate the resistance value of the second insulation resistance Rne when the PV voltage Vn and the bridge voltage Vs are received from the sensor unit 110.

Since the first resistor Rd1 and the second resistor Rd2 are applied with the high-voltage PV voltage Vn of the photovoltaic module 10, the first and second resistors are configured taking into account the capacity appropriate for the rating of the resistors such that the loss of the first resistor Rd1 and the second resistor Rd2 is preferably less than 1W because the resistance means the loss in terms of efficiency of the photovoltaic module 10.

For example, assuming that the maximum voltage of the photovoltaic module 10 is 550V and that the first resistor Rd1 and the second resistor Rd2 have the same resistance value, the resistance value of the first resistor Rd1 and the second resistor Rd2 2 may be determined as shown in Equation 19 below. At this time, since the bridge resistor Rs has a relatively small resistance value, it was ignored for the convenience of calculation.

【Equation 19】

$$R_{total} = Rd1 = Rd2 > \frac{Vmax^2}{1W} = \frac{550^2}{1} = 302.5 Kohm$$

Since the bridge resistor Rs shorts (0 ohm) when the first insulation resistance Rpe or the second insulation resistance Rne is in the worst condition, and at this time, the bridge voltage Vs becomes the maximum voltage value, it is desirable to configure the resistance value with a maximum input voltage of the sensor unit 110.

For example, assuming that the PV voltage Vn of the photovoltaic module 10 is 550V, the resistance values of the first resistor Rd1 and the second resistor Rd2 are 480 kohm, the initial input of the sensor unit 110 is 2V, and at this time, when the first insulation resistance Rpe shorts, the bridge voltage Vs is 2V, and when the second insulation resistance Rne shorts, the bridge voltage Vs is -2V, so the bridge voltage has a symmetrical structure, and therefore, for convenience of calculation, when the second insulation resistance Rne shorts, that is, the resistance value of the first insulation resistance Rpe is infinite, and when the second insulation resistance Rne shorts, the bridge resistor Rs may be determined as shown in Equation 20 below.

【Equation 20】

$$Rs = \frac{Rd1}{\frac{Vn}{Vs} - 2} = \frac{480K}{\frac{550}{2} - 2} \leq 1758.2 ohm$$

Here, it is desirable to determine a resistance value of the bridge resistor Rs according to the input range of a sensor constituting the sensor unit 110.

The determination unit 150 may determine the insulation status of the photovoltaic module 10 based on the first and second insulation resistances Rpe and Rne.

Specifically, the determination unit 150 may determine that the photovoltaic module 10 has an abnormal insulation status when the first and second insulation resistances Rpe and Rne are less than a reference value.

In contrast, the determination unit 150 may determine that the photovoltaic module 10 has a normal insulation status when the first and second insulation resistances Rpe and Rne are the reference value or more, and the controller 160 may open the relay S and connect the photovoltaic module 10 to a power conversion device to drive the photovoltaic module 10.

On the other hand, theoretically, while in a state of the relay S being opened, no current flows through the bridge resistor Rs due to bridge equilibrium, due to the error in the first resistor Rd1 and the second resistor Rd2, in a state of the relay S being opened, a small amount of current may flow through the bridge resistor Rs.

Accordingly, the sensor unit 110 may detect an offset voltage $\triangle$Vs between the first node N1 and the second node N2 in a state of the relay S being opened, and the offset correction unit 130 may reflect the offset voltage $\triangle$Vs in the bridge voltage Vs to correct the bridge voltage Vs.

Accordingly, the error of the first resistor Rd1 and the second resistor Rd2 may be ignored, and more accurate first and second insulation resistances Rpe and Rne may be calculated.

The calculation unit 140 may calculate the first and second insulation resistances Rpe and Rne based on the bridge voltage Vs' corrected by the offset correction unit 130.

The level conversion unit 120 may convert the PV voltage Vn and the bridge voltage Vs' into a level that the calculation unit 140 may process and provide the converted level to the calculation unit 140.

In this way, the device for checking the insulation state of the photovoltaic module 10 according to an embodiment of the present invention can accurately check the insulation state of the photovoltaic module 10 before being connected to the power conversion device of the photovoltaic module 10, In particular, it has the advantage of being able to accurately check the insulation status even in low-voltage sections other than the maximum voltage of the photovoltaic module. Through this, the risk of electric shock or fire due to ground fault current can be prevented.

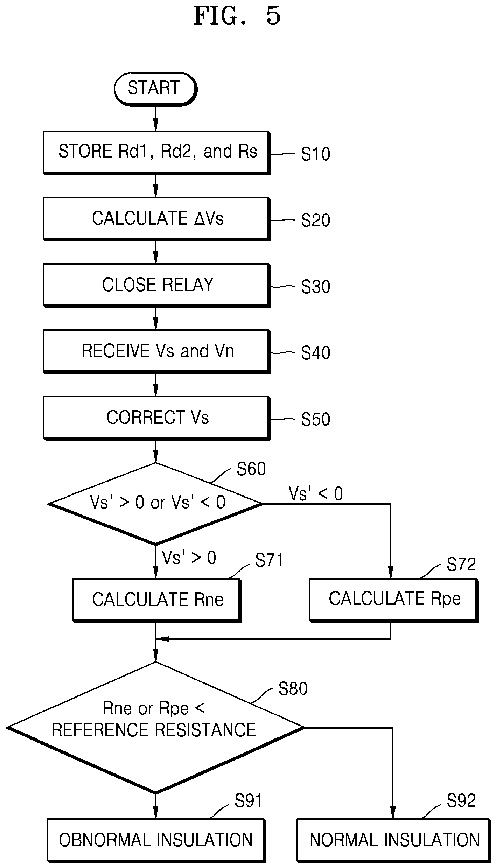

FIG. 5 is a flow chart of a method for checking the insulation status of a photovoltaic module according to an embodiment of the present invention.

Hereinafter, with reference to FIG. 5, a method for checking the insulation state of a photovoltaic module according to an embodiment of the present invention will be described, but the same content as described above will be omitted.

First, the calculation unit 140 stores the resistance values of the first resistor (Rd1), the second resistor (Rd2), and the bridge resistor (Rs) constituting the bridge circuit 101 (S10).

Next, with the relay S open, the sensor unit 110 detects the offset voltage $\triangle$Vs between the first node N1 and the second node N2 of the bridge circuit 101 (S20) ).

Next, in order to calculate the insulation resistance of the photovoltaic module 10, the controller 160 closes the relay (S30).

Next, the sensor unit 110 detects the PV voltage (Vn) of the photovoltaic module 10 and the bridge voltage (Vs).

Next, the calculation unit 140 receives the PV voltage (Vn) and the bridge voltage (Vs) from the sensor unit 110 (S40).

Next, the offset correction unit 130 corrects the bridge voltage (Vs) by reflecting the offset voltage ($\triangle$Vs) in the bridge voltage (Vs) (S50).

Next, the calculation unit 140 determines whether the corrected bridge voltage Vs' has a negative (-) voltage value or a positive (+) voltage value (S60).

Here, the calculation unit 140 calculates the first insulation resistance (Rpe) when the bridge voltage (Vs') has a negative (-) voltage value (S72), and when the bridge voltage (Vs') has a positive (+) voltage value, the calculation unit 140 calculates the first insulation resistance (Rpe) (S72). When the value is found, the second insulation resistance (Rne) is calculated (S71).

Next, the determination unit 150 determines that the insulation is abnormal when the first insulation resistance (Rpe) or the first insulation resistance (Rpe) is less than the reference resistance value (S91). When (Rpe) is greater than the standard resistance value, the insulation is judged to be normal (S92).

Accordingly, the method for checking the insulation status of the photovoltaic module 10 according to an embodiment of the present disclosure has advantages of accurately checking the insulation status of the photovoltaic module 10 before connected to a power conversion device of the photovoltaic module, in particular even when the photovoltaic module is not in a maximum voltage range, but in a low voltage range. Accordingly, the risk of electric shock or fire due to ground fault current may be prevented.

Accordingly, the method for checking the insulation status of the photovoltaic module according to an embodiment of the present disclosure has an advantage in that even when the resistance value of the insulation resistance has a wide distribution range depending on the types of photovoltaic modules 10 or power conversion devices, the distribution range of the insulation resistance may be reduced with the second resistor Rh2.

While the detailed description of the present disclosure has illustrated specific embodiments, various modifications are of course possible without departing from the scope of the present disclosure. Therefore, the scope of the present disclosure is not limited to the described embodiments, but should be defined by the claims described below and equivalents to these claims.

**Claims**

1. A device for checking the insulation status of a photovoltaic module, the device comprising:

   a photovoltaic module;
   a bridge circuit connected to the photovoltaic module and having two first resistors connected in series and two second resistors connected in series wherein the two first resistors and the two second resistors are connected in parallel;
   a sensor unit detecting a PV voltage of the photovoltaic module and a bridge voltage between a first node as a contact of the two first resistors and a second node as a contact of the two second resistors;

a relay connected between the first node or the second node and the ground;
a controller closing or opening the relay; and
an calculation unit calculating an insulation resistance between the photovoltaic module and the ground based on the PV voltage and the bridge voltage.

2. The device of claim 1, wherein

the bridge circuit is configured such that
a third node as one of the contacts of the two first resistors and two second resistors is connected to a positive terminal of the photovoltaic module, and a fourth node as the other contact is connected to a negative terminal of the photovoltaic module.

3. The device of claim 1, wherein

the sensor unit is configured
to detect the PV voltage and the bridge voltage when the relay is closed.

4. The device of claim 1, further comprising:
a determination unit determining the insulation status of the photovoltaic module based on the insulation resistance.

5. The device of claim 4, wherein

the determination unit is configured
to determine that the photovoltaic module has an abnormal insulation status when the insulation resistance is less than a reference value.

6. The device of claim 2, wherein

The calculation unit is configured
to calculate a first insulation resistance between the third node and the ground or a second insulation resistance between the fourth node and the ground depending on the polarity of the bridge voltage.

7. The device of claim 6, wherein

the calculation unit is configured
to calculate the first insulation resistance when the bridge voltage is a negative voltage, or the second insulation resistance when the bridge voltage is a positive voltage.

8. The device of claim 1, wherein
the bridge circuit further comprises:
a bridge resistor connected between the first node and second node, and the sensor unit detects a voltage across the bridge resistor as the bridge voltage.

9. The device of claim 8, wherein

the calculation unit is configured
to calculate the insulation resistance based on the resistance values of the first resistors, the second resistors, and the bridge resistor, the PV voltage, and the bridge voltage.

10. The device of claim 1, wherein

the sensor unit is configured
to detect an offset voltage between the first node and second node when the relay is opened.

11. The device of claim 10, further comprising:
an offset correction unit correcting the bridge voltage by reflecting the offset voltage on the bridge voltage.

12. The device of claim 11, wherein

the calculation unit is configured
to calculate the insulation resistance based on the bridge voltage corrected by the offset correction unit.

**13.** The device of claim 1, further comprising:
a level conversion unit converting the PV voltage and the bridge voltage into a level that the calculation unit is able to process and providing the same to the calculation unit.

**14.** A method of checking the insulation status of a photovoltaic module,
performed by a device for checking the insulation status of the photovoltaic module, the method comprising:

individually storing resistance values of two first resistors connected in series, two second resistors connected in series, a bridge resistor of a bridge circuit connected to the photovoltaic module;
while a relay, connected between a first node as a contact of the two first resistors or a second node as a contact of the two second resistors and a ground, is closed, detecting a PV voltage of the photovoltaic module and a bridge voltage between the first node and the second node;
calculating an insulation resistance of the photovoltaic module based on the resistance values of the first resistors, the second resistors, and the bridge resistor, the PV voltage, and the bridge voltage; and
determining being in a normal insulation status when the insulation resistance is a reference resistance value or more.

**15.** The method of claim 14, wherein
the detecting step further comprises:

detecting an offset voltage between the first node and the second node in a state of the relay being opened; and
correcting the bridge voltage based on the offset voltage.

# FIG. 1

# FIG. 2

# FIG. 3

# FIG. 4

# FIG. 5

```
                    ┌─────────┐
                    │  START  │
                    └────┬────┘
                         │
           ┌─────────────────────────┐
           │  STORE Rd1, Rd2, and Rs │ ── S10
           └─────────────┬───────────┘
                         │
           ┌─────────────────────────┐
           │      CALCULATE ΔVs       │ ── S20
           └─────────────┬───────────┘
                         │
           ┌─────────────────────────┐
           │       CLOSE RELAY        │ ── S30
           └─────────────┬───────────┘
                         │
           ┌─────────────────────────┐
           │     RECEIVE Vs and Vn    │ ── S40
           └─────────────┬───────────┘
                         │
           ┌─────────────────────────┐
           │        CORRECT Vs        │ ── S50
           └─────────────┬───────────┘
                         │
                  ╱──────────────╲  ── S60
                 ╱  Vs' > 0 or    ╲        Vs' < 0
                ╲   Vs' < 0       ╱ ───────────────┐
                 ╲──────────────╱                  │
                    │ Vs' > 0                       │
          ┌────────────────────┐      ┌────────────────────┐
          │   CALCULATE Rne     │─S71  │   CALCULATE Rpe     │─S72
          └─────────┬──────────┘      └──────────┬─────────┘
                    │                            │
                    │◄───────────────────────────┘
                    │
            ╱────────────────────╲  ── S80
           ╱    Rne or Rpe <       ╲
          ╲  REFERENCE RESISTANCE  ╱ ──────────────┐
           ╲────────────────────╱                  │
                    │                               │
          ┌────────────────────┐      ┌────────────────────┐
          │ OBNORMAL INSULATION │─S91  │  NORMAL INSULATION  │─S92
          └────────────────────┘      └────────────────────┘
```

## INTERNATIONAL SEARCH REPORT

International application No.

**PCT/KR2023/004923**

### A. CLASSIFICATION OF SUBJECT MATTER

**H02S 50/00**(2014.01)i

According to International Patent Classification (IPC) or to both national classification and IPC

### B. FIELDS SEARCHED

Minimum documentation searched (classification system followed by classification symbols)

H02S 50/00(2014.01); G01R 27/18(2006.01); G01R 31/12(2006.01); G01R 31/26(2006.01); H02J 3/38(2006.01); H02S 50/10(2014.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 태양광(solar, photovoltaic), 절연(insulation), 점검(inspection), 저항(resistor), 브릿지(bridge)

### C. DOCUMENTS CONSIDERED TO BE RELEVANT

| Category* | Citation of document, with indication, where appropriate, of the relevant passages | Relevant to claim No. |
|---|---|---|
| A | KR 10-2016-0116656 A (DASS TECH CO., LTD.) 10 October 2016 (2016-10-10)<br>See paragraphs [0014]-[0050], and figure 1. | 1-15 |
| A | KR 10-1999-0009238 A (KOREA RESEARCH INSTITUTE OF STANDARDS AND SCIENCE) 05 February 1999 (1999-02-05)<br>See paragraphs [0021]-[0023], and figure 1. | 1-15 |
| A | JP 2017-106762 A (KYORITSU ELECTRICAL INSTRUMENTS WORKS, LTD.) 15 June 2017 (2017-06-15)<br>See entire document. | 1-15 |
| A | US 2012-0223734 A1 (TAKADA, Shinichi et al.) 06 September 2012 (2012-09-06)<br>See entire document. | 1-15 |
| A | US 2017-0302082 A1 (DELTA ELECTRONICS (SHANGHAI) CO., LTD.) 19 October 2017 (2017-10-19)<br>See entire document. | 1-15 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **01 August 2023** | **01 August 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/004923**

| Patent document cited in search report | | | Publication date (day/month/year) | Patent family member(s) | | | Publication date (day/month/year) |
|---|---|---|---|---|---|---|---|
| KR | 10-2016-0116656 | A | 10 October 2016 | KR | 10-1682929 | B1 | 06 December 2016 |
| KR | 10-1999-0009238 | A | 05 February 1999 | KR | 10-0223972 | B1 | 15 October 1999 |
| JP | 2017-106762 | A | 15 June 2017 | JP | 6586651 | B2 | 09 October 2019 |
| US | 2012-0223734 | A1 | 06 September 2012 | EP | 2681571 | A2 | 08 January 2014 |
| | | | | JP | 2014-508939 | A | 10 April 2014 |
| | | | | US | 8773156 | B2 | 08 July 2014 |
| | | | | WO | 2012-122131 | A2 | 13 September 2012 |
| | | | | WO | 2012-122131 | A3 | 01 November 2012 |
| US | 2017-0302082 | A1 | 19 October 2017 | CN | 107305224 | A | 31 October 2017 |
| | | | | US | 10411479 | B2 | 10 September 2019 |

Form PCT/ISA/210 (patent family annex) (July 2022)